(19) Europäisches Patentamt / European Patent Office / Office européen des brevets

(11) **EP 1 838 760 B1**

(12) **EUROPEAN PATENT SPECIFICATION**

(45) Date of publication and mention
of the grant of the patent:
**03.08.2011 Bulletin 2011/31**

(51) Int Cl.:
**C08J 3/00** (2006.01)   **C08L 27/18** (2006.01)

(21) Application number: **05852582.5**

(22) Date of filing: **30.11.2005**

(86) International application number:
**PCT/US2005/043393**

(87) International publication number:
**WO 2006/060524 (08.06.2006 Gazette 2006/23)**

(54) **FLUOROPOLYMER MOLDING PROCESS AND FLUOROPOLYMER MOLDED PRODUCT**

FLUORPOLYMERFORMUNGSVERFAHREN UND FLUORPOLYMERGEFORMTES PRODUKT

PROCEDE DE MOULAGE DE POLYMERE FLUORE ET PRODUIT MOULE DE POLYMERE FLUORE

(84) Designated Contracting States:
**DE FR GB IT**

(30) Priority: **03.12.2004 JP 2004351927**

(43) Date of publication of application:
**03.10.2007 Bulletin 2007/40**

(73) Proprietor: **DUPONT-MITSUI
FLUOROCHEMICALS CO., LTD.
Tokyo 101-0064 (JP)**

(72) Inventor: **NISHIO, Takao
Shimizu-ku, Shizuoka 424-0856 (JP)**

(74) Representative: **Heinemann, Monica et al
Abitz & Partner
Patentanwälte
Postfach 86 01 09
81628 München (DE)**

(56) References cited:
**EP-A- 0 362 868     WO-A- 02/44266
US-A- 5 041 500     US-A1- 2002 010 277**

• **PATENT ABSTRACTS OF JAPAN vol. 017, no. 478 (C-1104), 31 August 1993 (1993-08-31) & JP 05 117477 A (DAIKIN IND LTD), 14 May 1993 (1993-05-14)**
• **PATENT ABSTRACTS OF JAPAN vol. 009, no. 267 (C-310), 24 October 1985 (1985-10-24) & JP 60 115652 A (UNITIKA KK), 22 June 1985 (1985-06-22)**
• **PATENT ABSTRACTS OF JAPAN vol. 015, no. 092 (C-0811), 6 March 1991 (1991-03-06) & JP 02 305844 A (CENTRAL GLASS CO LTD), 19 December 1990 (1990-12-19)**

**Description**

1. Field of the Invention

The present invention relates to a molding process for fluoropolymer molded products that have superior resistance to chemical and gas permeation, and a low coefficient of linear expansion, and to the fluoropolymer molded products obtained from said process.

2. Background of the Invention

Fluoropolymers that possess the characteristics of heat resistance and chemical resistance can be utilized in the linings of pipes or tanks, and in pipes used for transporting chemicals such as in semiconductor manufacturing processes or chemical plants, in joints such as flanges and couplings, and in chemical storage vessels.

Among fluoropolymers, polytetrafluoroethylene (PTFE) possesses the best characteristics such as heat resistance, chemical resistance, and has an unusually high melt viscosity of at least $10^8$ Pa·s at 380°C. Because of this high viscosity, PTFE does not possess melt flowability. Therefore melt fabrication processes such as extrusion, injection molding, blow molding, and transfer molding, cannot be used for fabricating PTFE.

Since PTFE is non-melt processable, it is fabricated using non-melt fabrication processes, such as paste extrusion and compression molding Paste extrusion is the process wherein a fine PTFE powder that has been fibrillated by application of shearing forces forms a mixture (paste) with a known lubricant. This paste is extruded at low temperature (not exceeding 75°C). Compression molding is the process wherein PTFE powder is maintained at a temperature above its glass transition point (Tg), is loaded into a mold and is then compressed with a ram, and heated (sintered) to effect molding.

However, in the paste extrusion process, the lubricant must be removed after paste extrusion. Furthermore, residual lubricant in the molded product can undergo carbonization, which can lead to problems such as discoloration of the molded product, and a reduction in chemical resistance and in the electronic characteristics. Additionally, in order to prevent the formation of cracks in the molded product due to too-rapid volatilization of the lubricant, the need to remove the lubricant by gradually raising the temperature is time-consuming and increases the length of the production cycle.

Moreover, compression molding is practical only for making simple shapes. When complex shapes are desired, a compression molded PTFE block must be machined to achieve this result.

Tetrafluoroethylene/perfluoro(alkyl vinyl ether) copolymer (PFA) possesses the advantages of superior heat resistance, and chemical resistance equal to that of PTFE, and can be used for melt molding such as extrusion, injection molding, blow molding, transfer molding, and melt compression molding. Because it is more economical to process, articles made from PFA have a lower cost than the same articles made from PTFE, and is suitable for mass production.

Nevertheless, since it is inferior to PTFE in terms of resistance to chemical and gas permeation, it has been suggested that the resistance to chemical and gas permeation can be improved by increasing the degree of crystallinity in the molded products through blending PTFE with PFA. However, since the PTFE usually employed as a molding powder has a high molecular weight, there is the problem that as the amount of PTFE added becomes greater, the accompanying viscosity increases markedly, making melt molding more difficult. At the same time, it is possible to use compositions that have higher viscosity to carry out non-melt molding, such as compression molding or paste extrusion molding, in the same manner as for PFTE, but this is not practical because of limitations on shape of the molded article, as noted above for such processes.

In Japanese Published Unexamined Applications 2002-167488 and 2003-327770, it is suggested that by using low molecular weight PTFE, also known as micropowder, the increase in viscosity can be avoided and melt molding is possible, and increased resistance to chemical and gas permeation can thus be achieved. However, the addition of low molecular weight PTFE affects mechanical strength adversely, so that the quantity of low molecular weight PTFE that can be added is limited.

Furthermore, when fluoroplymer molded products have been heated at temperatures above the melting point, the linear expansion coefficient becomes larger as compared to other materials, such as the metal that is used in piping. Thus in fluoropolymer-lined pipes the lining can warp when exposed to elevated temperatures, and this can cause leaks at the seals of joints. Since the linear expansion coefficient is smaller with a higher degree of crystallinity (where there is a smaller fraction of non-crystalline regions, which have a higher expansion coefficient) in the molded product, it is preferable for the degree of crystallinity in the molded product to be high. The degree of crystallinity in the molded product can be increased through slow cooling after heating, but the benefit is minor and it is not possible to obtain by this means a material improvement in resistance to chemical and gas permeation and reduced linear expansion coefficient.

The above identified Japanese published unexamined patent applications are incorporated herein by reference.

## Summary of the Invention

The present invention further provides a process wherein it is possible to obtain through melt fabrication a fluoropolymer product that has superior resistance to chemical and gas permeation, and a low coefficient of linear expansion.

The present invention provides a fluoropolymer molded product, obtained by said molding process, that has superior resistance to chemical and gas permeation, and a low coefficient of linear expansion.

The present invention provides a molding process wherein a mixture is obtained by combining at least two fluoropolymers, each having different melting points, and molding is carried out at a temperature that is at or above the melting point of the fluoropolymer with the lowest melting point and is less than the melting point of the fluoropolymer with the highest melting point.

The fluoropolymers used in the present invention comprise at least two fluoropolymers having different melting points and can be selected from the group consisting of polytetrafluoroethylene, tetrafluoroethylene/perfluoro(alkyl vinyl ether) copolymer, tetrafluoroethylene/hexafluoropropylene copolymer, ethylene/tetrafluoroethylene copolymer, ethylene/chlorotrifluoroethylene copolymer, polychlorotrifluoroethylene, poly(vinylidene fluoride), vinylidene fluoride/hexafluoropropylene copolymer, and tetrafluoroethylene/vinylidene fluoride/hexafluoropropylene copolymer.

A fluoropolymer molding process is a preferred mode of the present invention.

A preferred mode of the present invention is the fluoropolymer molding process wherein the fluoropolymers are polytetrafluoroethylene and tetrafluoroethylene/perfluoro(alkyl vinyl ether) copolymer.

A preferred mode of the present invention is the fluoropolymer molding process wherein the fluoropolymers are polytetrafluoroethylene and tetrafluoroethylene/hexafluoropropylene copolymer.

A preferred mode of the present invention is the fluoropolymer molding process wherein the polytetrafluoroethylene has a heat of fusion ($\Delta H$) of greater than or equal to 45 J/g.

The present invention also provides a fluoropolymer molded product obtained by the aforementioned fluoropolymer molding process.

A fluoropolymer molded product with a linear expansion coefficient between 100°C and 150°C of less than or equal to $15 \times 10^{-5}$/°K is a preferred mode of the present invention.

A fluoropolymer molded product with a specific gravity of greater than or equal to 2.180 is a preferred mode of the present invention.

The present invention provides a molding process for fluoropolymer molded products that have superior resistance to chemical and gas permeation, and a low coefficient of linear expansion, as well as a fluoropolymer molded product obtained from said molding process.

According to the fluoropolymer molding process of the present invention, by carrying out the molding on a mixture obtained by combining at least two of fluoropolymers that have different melting points, where the molding takes place at a temperature that is at or above the melting point of the fluoropolymer with the lowest melting point and is less than the melting point of the fluoropolymer with the highest melting point, the degree of crystallinity in the fluoropolymer with a high-melting point is maintained, so that the resulting fluoropolymer molded product has superior resistance to chemical and gas permeation, and a low coefficient of linear expansion.

Moreover, since there is the possibility of obtaining a fluoropolymer molding process of the present invention that is a melt molding process, it is possible to offer high polytetrafluoroethylene-content molded products having complex shapes.

Since the fluoropolymer molded products of the present invention possess superior performance such as superior resistance to chemical and gas permeation, and a low coefficient of linear expansion, the fluoropolymer molded products can find applications such as in semiconductors, preventing chemical corrosion (CPI), office automation (OA), sliding materials, automotive products (engine components such as electrical cables, oxygen sensors, and fuel hoses), and printed circuit boards.

## Brief Description of the Drawings

Fig. 1 is a photograph of the appearance of the extruded product (bead) obtained in Example 2.
Fig. 2 is a photograph of the appearance of the extruded product obtained in Comparative Example 1.

## Detailed Description of the Invention

The present invention provides a fluoropolymer molding process wherein a mixture obtained by combining at least two of fluoropolymers having different melting points, and carrying out the molding at a temperature that is at or above the melting point of the fluoropolymer with the lowest melting point and is less than the melting point of the fluoropolymer with the highest melting point, the mixture comprising 10-95 wt % of the high-melting point fluoropolymer and 90-5 wt% of the low-melting point fluoropolymer.

The present invention also provides a fluoropolymer molded product obtained by the aforementioned fluoropolymer molding process.

For preferred fluoropolymers of the present invention, the at least two fluoropolymers having different melting points are selected from the group consisting of polytetrafluoroethylene, tetrafluoroethylene/perfluoro(alkyl vinyl ether) copolymer (PFA), tetrafluoroethylene/hexafluoropropylene copolymer (FEP), ethylene/tetrafluoroethylene copolymer, ethylene/chlorotrifluoroethylene copolymer, polychlorotrifluoroethylene, poly(vinylidene fluoride), vinylidene fluoride/hexafluoropropylene copolymer, and tetrafluoroethylene/vinylidene fluoride/hexafluoropropylene copolymer.

Among these, polytetrafluoroethylene as the high-melting point fluoropolymer and PFA and/or FEP as the low-melting point fluoropolymer are preferable. Polytetrafluoroethylene with a heat of fusion (ΔH) of greater than or equal to 45 J/g is preferred. If the heat of fusion (ΔH) is less than 45 J/g, the degree of crystallinity will be lower and there will be less improvement of the resistance to chemical and gas permeation, and linear expansion coefficient. The typical melting points of these polymers are as follows: polytetrafluoroethylene - about 343°C (on the first melting; about 327°C on subsequent meltings); PFA - 275-310°C, depending upon comonomer (perfluoro(alkyl vinyl ether) content); and FEP - 250-280°C( depending upon comonomer (hexafluoropropylene) content).

From the point of view of the smoothness of the surface of the fluoropolymer molded product, smoothness being beneficial in most applications, particularly where cleanliness and ease of washability is important, PTFE melt flow rate (MFR) of less than 0 g/10 min is preferred as opposed to PTFE having a measurable MFR. With a polytetrafluoroethylene for which the MFR equal to or greater than 1 g/10 min, in other words when low molecular weight polytetrafluoroethylene (commonly called micropowder) is used, the surface of the fluoropolymer molded product will not be so smooth.

The term polytetrafluoroethylene (PTFE) as used herein means a homopolymer of tetrafluoroethylene, or a copolymer (sometimes referred to below as modified PTFE) of tetrafluoroethylene that includes less than 2 wt% of a copolymerizable fluoromonomer. The content of the copolymerizable fluoromonomer in the modified PTFE is preferably less than 2 wt%, more preferably less than or equal to 1.5 wt%, and further preferably less than or equal to 1 wt%. Polytetrafluoroethylene by itself, whether homopolymer or modified, is not melt processible by conventional melt processing methods such as extrusion.

In the aforementioned tetrafluoroethylene copolymer (modified PTFE), examples of copolymerizable fluoromonomer include olefines of C-3 (i.e. having three carbon atoms) or more and more preferably perfluoroalkenes having three carbons or more, most preferably three to six carbons; C-1 to C-6 perfluoro(alkyl vinyl ether) wherein the alkyl groups preferably have from one to six carbon atoms; chlorotrifluoroethylene, and the like. Specific examples that can be mentioned of the included copolymerizable fluoromonomer that are preferred include hexafluoropropylene (HFP), perfluoro(methyl vinyl ether) (PMVE), perfluoro(ethyl vinyl ether) (PEVE), perfluoro(propyl vinyl ether) (PPVE), and perfluoro(butyl vinyl ether) (PBVE), and chlorotrifluoroethylene (CTFE). Among these, HFP, PEVE and PPVE are more preferred, and HFP is most preferred.

For the at least two fluoropolymers having different melting points used in the present invention, the use of aqueous dispersions obtained from emulsion polymerization is preferred. For the aqueous fluoropolymer dispersion, the mean particle diameter for the fluoropolymer particles is 0.10-0.40 μm, and preferably 0.2-0.3 μm, and a fluoropolymer content of 25-70 wt% in water is preferred. For the process of obtaining the aqueous fluoropolymer dispersion, any conventionally known process that is suitable can be used. For example, it is satisfactory to use the processes described in Japanese Published Examined Applications 37-4643,46-14466, and 56-26242.

For the mixture obtained by mixing at least two fluoropolymers having different melting points, the mixture comprises 10-95 wt% of the high-melting point fluoropolymer and 90-5 wt% of the low-melting point fluoropolymer. The mixing ratio is determined by consideration of the desired resistance to chemical and gas permeation, linear expansion coefficient, maximum strength, and elongation. However, having the proportion of the high-melting point fluoropolymer less than 10 wt% is not preferable because the degree of crystallinity in the fluoropolymer molded product will be low. Moreover, having the proportion of the low-melting point fluoropolymer less than 5 wt% is not preferable because the mechanical strength of the fluoropolymer molded product will be inferior (e.g. tensile strength and elongation will be inferior).

While there are no particular limitations on the process for obtaining said mixture, a preferred process is the mixing of an aqueous dispersion containing the high-melting point fluoropolymer with an aqueous dispersion containing the low-melting point fluoropolymer. When the mixture of the present invention is obtained by said process, the composition of the mixture will reflect the preferred ranges of compositions for the respective fluoropolymer aqueous dispersions, while the mixing ratio can be suitably adjusted as preferred.

A mixture of the present invention obtained by emulsion polymerization that is a preferred specific example is the one wherein a high-melting point fluoropolymer aqueous dispersion (for example, with a mean particle diameter of

0.24 $\mu$m) and a low-melting point fluoropolymer aqueous dispersion (for example, with a mean particle diameter of 0.24 $\mu$m) are mixed together in a proportion of from 95:5 to 10:90 based on weights of polymer in the dispersions, and after stirring and coagulation the coagulate obtained is dried to give a powder that has a mean particle diameter on the order of 300-600 $\mu$m, more preferably on the order of 400 $\mu$m.

A recommended melt flowability (F) (a measure of shear-thinning or thixotropy) for the mixture of the present invention of is preferably greater than or equal to 0.1 and more preferably is equal to 1.0 or greater than 1.0. If the melt flowability (F) is too small, the decreased melt viscosity of the mixture due to the increased rate of shear (shear stress) will be disadvantageous, and the processability will tend to become worse. The melt flowability (F) can be determined from Formula (1) below.

$$F \ = \ \frac{\log(MV1) - \log(MV2)}{\log(\gamma 2) - \log(\gamma 1)} \qquad (1)$$

(where y = shear rate (sec$^{-1}$); MV1 = melt viscosity with shear rate $\gamma$1; MV2 = melt viscosity with shear rate $\gamma$2).

The viscosity as a function of shear rate can be determined from Equation (2) below.

$$MV(poise) = \Delta P/\gamma \qquad (2)$$

(Where $\Delta P$= pressure (MPa) during extrusion of a powdered sample at a fixed shear rate ($\gamma$), using a capillary flow tester (Capillograph 1B, Toyo Seiki Co., Ltd.) and increasing the temperature of the orifice (diameter ($\varphi$): 2 mm; length (L): 20 mm) at the cylinder bottom to a fixed molding temperature). In terms of the International System of Units Equation (2) is:

$$MV(Pa \cdot s) = \Delta P/(10\gamma) \qquad (2)$$

For the mixture obtained as described above, any desired additives may be included if needed. Examples of such additives include antioxidants, photostabilizers, fluorescent whiteners, pigments, colorants, dyes, fillers, for example carbon black, graphite, alumina, mica, silicon carbide, boron nitride, titanium oxide, bismuth oxide, bronze, gold, silver, steel, and nickel. These may be in appropriate form such as powders, powdered fibers, or fibers. Nanomaterials that have recently entered mass production and have been commercialized, such as fullerene (C60) and carbon nanotubes, can also be used as additives. Moreover, microparticles of other polymers in addition to fluoropolymers, and other components may be included and used so long as they are not detrimental to the objectives of the present invention.

The preferred molding process for the fluoropolymers in the present invention is a melt molding process carried out on a mixture obtained by combining at least two fluoropolymers having different melting points, at a temperature that is at or above the melting temperature of the lowest melting point fluoropolymer and is below the melting temperature of the highest melting point fluoropolymer. Examples of such molding processes include extrusion, injection molding, transfer molding, and melt compression molding. For high PTFE content mixtures of the present invention, the molding process can be paste extrusion or compression molding.

When the highest melting point fluoropolymer is PTFE and the lowest melting point fluoropolymer is PFA, a bead or pellet can be molded at a temperature that is at or above the melting temperature of the PFA and is below the melting temperature of the PTFE using the mixture powder obtained as above (by mixing aqueous dispersions of the two polymers, coagulating and drying the resulting mixture). The bead can be cut into pellets which can be used to carry out continuous melt extrusion at a temperature that is at or above the melting temperature of the lowest melting point fluoropolymer and is below the melting temperature of the highest melting point fluoropolymer. Any unstable end groups contained in said beads or pellets can be reduced in concentration such as through fluorination.

In addition, after obtaining a preformed body by compression of said mixture with a known paste extrusion lubricant, said preformed body is placed in a paste extruder, and is extruded, and said lubricant removed, at a temperature that is at or above the melting point of the fluoropolymer with the lowest melting point and is less than the melting point of the fluoropolymer with the highest melting point.

In the fluoropolymer molding process of the present invention, carrying out the process at a temperature that is below the melting temperature of the low-melting point fluoropolymer is not preferable, because there is an accompanying rise in the molding pressure, and the strength and elongation of the fluoropolymer molded product will be inferior. Moreover, carrying out the molding at a temperature that is at or above the melting temperature of the high-melting point fluoropolymer is not preferable, because the degree of crystallinity in the fluoropolymer molded product obtained will be lowered, and it will not be possible to achieve superior resistance to chemical and gas permeation and a desirably low linear expansion coefficient.

In the fluoropolymer molding process of the present invention, since melt molding can be carried out while maintaining a high degree of crystallinity in the high-melting point fluoropolymer, a fluoropolymer molded product can be obtained which has superior resistance to chemical and gas permeation, and a low linear expansion coefficient.

A fluoropolymer molded product of the present invention that has a linear expansion factor less than or equal to $15 \times 10^{-5}$/°K between 100°C and 150°C is preferred, because it will have superior dimensional stability at those temperatures. If the linear expansion factor is too large under high temperature usage conditions, there will be a concern that the fluoropolymer molded product obtained will become deformed, so that, for example, the seal between a tube and a joint will fail and chemicals might leak out.

The specific gravity of a fluoropolymer molded product of the present invention is preferably greater than or equal to 2.160, and more preferably greater than or equal to 2.180. The specific gravity of a fluoropolymer is an index of the degree of crystallinity of the polymer: lower specific gravity means lower crystallinity. As a consequence, resistance to chemical and gas permeation will tend to be lower also.

Without being limited in any particular way, a fluoropolymer molded product of the present invention will find use in applications that require resistance to chemical and gas permeation and a low coefficient of linear expansion, for example tubes, seals, rods, fibers, packing, cables, linings, and laminated bodies that employ molded products of the present invention.

Fluoropolymer molded products of the present invention are suitable for applications such as in semiconductors, CPI, OA, sliding materials, automotive products (engine components such as electrical cables, oxygen sensors, and fuel hoses), and printed circuit boards.

## Examples

The present invention is explained below in more detail by way of examples of embodiments and comparison examples, but this discussion is not meant to limit the present invention in any way.

The measurements of physical properties were carried out according to the following methods:

(1) Melting point (melting peak temperature)

A differential scanning calorimeter (Pyris1 DSC, Perkin Elmer) was used. A 10 mg portion of the powdered polymer sample is weighed out into an aluminum pan, and after being crimped closed with a crisper, is placed in the main DSC unit, and the temperature is increased from 150°C to 360°C at the rate of 10°C/min. The peak temperature (maximum temperature of the melting endotherm) (Tm) is determined from the melting curve obtained in this process, and this is the melting temperature.

(2) Melt flow rate (MFR)

An ASTM D-1238-95-compliant corrosion resistant melt indexer (Toyo Seiki Co., Ltd.) equipped with a cylinder, die and piston is used, and after 5 g to the powdered polymer sample is packed into the cylinder that is maintained at $372 \pm 1$°C and kept there for 5 min, the sample is forced through the die orifice under a 5 kg load (piston plus added weight), and the MFR is expressed as the polymer extrusion rate in units of g/10 min.

(3) Heat of fusion

A differential scanning calorimeter (Pyris1 DSC, Perkin Elmer) is used. A 10 mg portion of the powdered polymer sample is weighed out into an aluminum pan, and after being crimped closed with a crimper, is placed in the main DSC unit, and the temperature is increased from 150°C to 360°C at the rate of 10°C/min. From the melting curve obtained in this process, the heat of fusion is determined from the area defined by the melting curve on either side of the melting peak, and a straight line connecting the point where the melting curve separates from the baseline to the point where it returns to the baseline.

(4) Specific gravity

A compression molding device (Hot Press WFA-37, Shinto Industry Co., Ltd.) is used, and the powdered polymer sample is melt compression molded (4 MPa) at the extruding temperature shown in Table 1 to obtain a sheet with a thickness of approximately 1.0 mm. A sample piece (height: 20 mm; width: 20 mm) is cut from the sheet obtained, and the specific gravity is determined according to Method A (water displacement method) of JIS K711.

(5) Resistance to chemical and gas permeation

A compression molder (Hot Press WFA-37, Shinto Industry Co., Ltd.) is used, and the powdered sample is melt compression molded (4 MPa) at the extruding temperature shown in Table 1 to obtain a sheet with a thickness of approximately 1.0 mm. A gas permeability measuring apparatus (Shibata Chemical Instrument Co., Model No. S-69) is used to measure the nitrogen gas permeability of the sheet obtained at a temperature of 23°C.

(6) Linear expansion coefficient

A compression molder (Hot Press WFA-37, Shinto Industry Co., Ltd.) is used, and the powdered sample is melt compression molded (4 MPa) at the extruding temperature shown in Table 1 to obtain a billet. A lathe is used to cut a measurement sample (diameter: 4 mm; length: 20 mm) from the billet obtained. A TMA TM-7000 apparatus (Vacuum Engineering, Inc.) was used, and the temperature was increase at the rate of 5°C/min over the range -10°C to 270°C. The dimensional changes were measured between 100°C and 150°C, and the linear expansion coefficient was determined according to ASTM D696.

(7) Extrudate surface, tensile strength and elongation at break

A capillary flow tester (Capillograph 1B, Toyo Seiki Co., Ltd.) was used, and the powdered polymer sample was ram-extruded at a shear rate of 15.2 s$^{-1}$ from the orifice (diameter: 2 mm; length: 20 mm) at the cylinder bottom, which is controlled at the extruding temperature shown in Table 1, to obtain a bead. For the extrudate surface of the bead obtained, a stylus-type surface roughness tester (SURFCOM 575A-3D, Tokyo Seimitsu) is used to measure the surface roughness (R(a)) at 5 arbitrarily chosen points, and the surface is considered to be smooth when the mean value for the surface roughness (R(a)) over the 5 points is less than or equal to about 100 $\mu$m. In addition, a Tensilon RTC-1310A (Orientec Co., Ltd.) is used for determining the maximum tensile strength to break and the elongation to break for the bead obtained. The measurements were made with a chuck gap distance of 22.2 mm and a stretching rate of 50 mm/min.

Raw materials

The raw materials used in the embodiments of the present invention and for the comparison examples are as described below.

(1) Aqueous dispersion of modified PTFE

An aqueous dispersion of approximately 30 wt% of PTFE modified with 0.3 wt% hexafluoropropylene (mean particle diameter = 0.24 $\mu$m; melting point = 343°C; MFR = 0 g/10 min, heat of fusion ($\Delta$H) = 70 J/g).

(2) Aqueous dispersion of PFA

An aqueous dispersion of approximately 45 wt% of tetrafluoroethylene/perfluoro(ethyl vinyl ether) copolymer (mean particle diameter = 0.24 $\mu$m; melting point = 285°C; MFR = 30 g/10 min).

(3) Aqueous dispersion of FEP

An aqueous dispersion of approximately 36.5 wt% of tetrafluoroethylene/hexafluoropropylene copolymer (mean particle diameter = 0.18 $\mu$m; melting point = 259.5°C; MFR = 24.1 g/10 min).

Preparation of the powdered polymer samples

Aqueous dispersions of fluoropolymers with different melting points were blended to give ratios as shown as shown in Table 1, where the weights of the resins are given in wt%. The dispersion blends were coagulated by high speed agitation (mechanical coagulation). The coagulate thus obtained was filtered to separate the solids from water, the solids were dried for 16 hours at 270°C, to furnish powdered samples having a mean particle diameter of 300-800 $\mu$m.

## Examples 1-5 and Comparative Examples 1 and 2

Measurements are made of MFR for the powdered samples, and of the specific gravity, nitrogen gas permeability, linear expansion coefficient, extrudate surface, maximum strength and elongation for the molded products obtained by molding the powdered samples at the temperatures shown in Table 1. The results are summarized in Table 1.

| Table 1 | | | | | | | |
|---|---|---|---|---|---|---|---|
| | Example 1 | Example 2 | Example 3 | Example 4 | Example 5 | Comparative Example 1 | Comparative Example 2 |
| High-melting point fluoropolymer (wt%) | PTFE 30 | PTFE 50 | PTFE 70 | PTFE 90 | PTFE 50 | PTFE 50 | PTFE 50 |
| Low-melting point fluoropolymer (wt%) | PFA 70 | PFA 50 | PFA 30 | PFA 10 | FEP 50 | PFA 50 | FEP 50 |
| MFR at 372°C (g/10 min) | 0 | 0 | 0 | 0 | 0 | 0 | 0 |
| Extruding temperature (°C) | 320 | 320 | 320 | 320 | 320 | 380 | 380 |
| Specific gravity - | 2.187 | 2.217 | 2.246 | 2.277 | 2.221 | 2.152 | 2.173 |
| Nitrogen gas permeability ($cm^3$ (STP) $\cdot cm\ /cm^2 \cdot sec \cdot cm\ Hg$) | $0.24 \times 10^{-10}$ | $0.15 \times 10^{-10}$ | $0.05 \times 10^{-10}$ | $0.02 \times 10^{-10}$ | $0.11 \times 10^{-10}$ | $0.48 \times 10^{-10}$ | $0.68 \times 10^{-10}$ |
| Linear expansion coefficient (/°K) | $16.1 \times 10^{-5}$ | $13.3 \times 10^{-5}$ | $7.8 \times 10^{-5}$ | $2.1 \times 10^{-5}$ | $12.0 \times 10^{-5}$ | $26.1 \times 10^{-5}$ | $16.8 \times 10^{-5}$ |
| Extrudate surface - | Smooth | Smooth | Smooth | Smooth | Smooth | Molding not possible | Molding not possible |
| Tensile at break (MPa) | 14.7 | 25.6 | 22.1 | 26.3 | 21.3 | - | - |
| Elongation at break (%) | 53 | 54 | 22 | 10 | 73 | - | - |

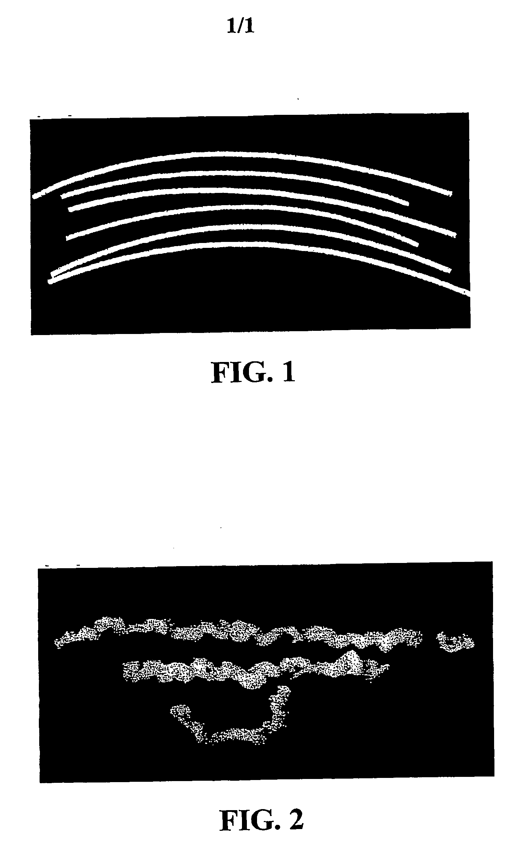

It is seen that mixtures that are extruded at temperatures above the melting point of the lower melting PFA or FEP and below the melting point of the higher melting PTFE have higher density and lower crystallinity and lower coefficient of linear expansion. The condition of the extrudate of Example 2 is shown in Fig. 1 and is smooth and even. The condition of the extrudate of Comparative Example 1 (same PTFE:PFA blend as Example 1, but extruded at 380°C, i.e. above the melting point of the higher melting component of the blend (PTFE)), is poor compared to that of the extrudate of Fig. 1, showing much unevenness. Such a blend could not be molded.

The present invention provides a molding process for fluoropolymer molded products that have superior resistance to chemical and gas permeation, and a low coefficient of linear expansion, as well as a fluoropolymer molded product obtained from said molding process.

Along with being able to employ molding, it is possible with the fluoropolymer molding process of the present invention to obtain a fluoropolymer molded product with superior resistance to chemical and gas permeation and a low coefficient of linear expansion.

Since the fluoropolymer molded products of the present invention possess superior performance such as superior resistance to chemical and gas permeation, and a low coefficient of linear expansion, these fluoropolymer molded products can find possible applications, as for example, in semiconductors, the chemical process industry (CPI), OA, sliding materials, automotive products (engine components such as electrical cables, oxygen sensors, and fuel hoses), and in printed circuit boards.

**Claims**

1. A fluoropolymer molding process comprising molding a mixture of at least two fluoropolymers having different melting points at a temperature that is at or above the melting point of the fluoropolymer with the lowest melting point and is less than the melting point of the fluoropolymer with the highest melting point, the mixture comprising 10-95 wt % of the high-melting point fluoropolymer and 90-5 wt % of the low-melting point fluoropolymer.

2. The fluoropolymer molding process as recited in claim 1, wherein the at least two fluoropolymers having different melting points are selected from the group consisting of polytetrafluoroethylene, tetrafluoroethylene/perfluoro(alkyl vinyl ether) copolymer, tetrafluoroethylene/hexafluoropropylene copolymer, ethylene/tetrafluoroethylene copolymer, ethylene/chlorotrifluoroethylene copolymer, polychlorotrifluoroethylene, poly(vinylidene fluoride), vinylidene fluoride/hexafluoropropylene copolymer, and tetrafluoroethylene/vinylidene fluoride/hexafluoropropylene copolymer.

3. The fluoropolymer molding process as recited in claim 1, wherein the fluoropolymers are polytetrafluoroethylene and tetrafluoroethylene/perfluoro(alkyl vinyl ether) copolymer.

4. The fluoropolymer molding process as recited in claim 1, wherein the fluoropolymers are polytetrafluoroethylene and tetrafluoroethylene/hexafluoropropylene copolymer.

5. The fluoropolymer molding process as recited in claim 2, wherein the crystalline heat of fusion (AH) of the polytetrafluoroethylene is greater than or equal to 45 J/g.

6. A fluoropolymer molded product obtained by the fluoropolymer molding process as recited in claim 1.

7. The fluoropolymer molded product as recited in claim 6, wherein the linear expansion index between 100°C and 150°C for the fluoropolymer molded product is less than or equal to $15 \times 10^{-5}$/°K.

8. The fluoropolymer molded product as recited in claim 6, wherein the specific gravity of the fluoropolymer molded product is greater than or equal to 2.160.

**Patentansprüche**

1. Fluorpolymerformungsverfahren umfassend das Formen einer Mischung von mindestens zwei Fluorpolymeren, die verschiedene Schmelzpunkte aufweisen, bei einer Temperatur, die bei oder über dem Schmelzpunkt des Fluorpolymers mit dem niedrigsten Schmelzpunkt und unter dem Schmelzpunkt des Fluorpolymers mit dem höchsten Schmelzpunkt liegt, wobei die Mischung 10-95 Gew.-% des Fluorpolymers mit hohem Schmelzpunkt und 90-5 Gew.-% des Fluorpolymers mit niedrigem Schmelzpunkt umfasst.

**2.** Fluorpolymerformungsverfahren wie in Anspruch 1 aufgeführt, wobei die mindestens zwei Fluorpolymere, die verschiedene Schmelzpunkte aufweisen, aus der Gruppe ausgewählt sind bestehend aus Polytetrafluorethylen, Tetrafluorethylen-Perfluor(alkylvinylether)-Copolymer, Tetrafluorethylen-Hexafluorpropylen-Copolymer, Ethylen-Tetrafluorethylen-Copolymer, Ethylen-Chlortrifluorethylen-Copolymer, Polychlortrifluorethylen, Poly(vinylidenfluorid), Vinylidenfluorid-Hexafluorpropylen-Copolymer und Tetrafluorethylen-Vinylidenfluorid-Hexafluorpropylen-Copolymer.

**3.** Fluorpolymerformungsverfahren wie in Anspruch 1 aufgeführt, wobei die Fluorpolymere Polytetrafluorethylen und Tetrafluorethylen-Perfluor(alkylvinylether)-Copolymer sind.

**4.** Fluorpolymerformungsverfahren wie in Anspruch 1 aufgeführt, wobei die Fluorpolymere Polytetrafluorethylen und Tetrafluorethylen-Hexafluorpropylen-Copolymer sind.

**5.** Fluorpolymerformungsverfahren wie in Anspruch 2 aufgeführt, wobei die kristalline Schmelzwärme ($\Delta$H) des Polytetrafluorethylens höher als oder gleich 45 J/g ist.

**6.** Geformtes Fluorpolymerprodukt, das durch das Fluorpolymerformungsverfahren wie in Anspruch 1 aufgeführt erhalten wird.

**7.** Geformtes Fluorpolymerprodukt wie in Anspruch 6 aufgeführt, wobei der lineare Dehnungsindex zwischen 100 °C und 150 °C bei dem geformten Fluorpolymerprodukt weniger als oder gleich 15 x $10^{-5}$/°K beträgt.

**8.** Geformtes Fluorpolymerprodukt wie in Anspruch 6 aufgeführt, wobei das spezifische Gewicht des geformten Fluorpolymerprodukts höher als oder gleich 2,160 ist.

**Revendications**

**1.** Procédé de moulage de polymères fluorés comprenant le moulage d'un mélange d'au moins deux polymères fluorés ayant des points de fusion différents à une température qui est située au niveau ou au-dessus du point de fusion du polymère fluoré ayant le point de fusion le plus bas et qui est inférieure au point de fusion du polymère fluoré ayant le point de fusion le plus élevé, le mélange comprenant 10 à 95 % en poids du polymère fluoré à point de fusion élevé et 90 à 5 % en poids du polymère fluoré à point de fusion bas.

**2.** Procédé de moulage de polymères fluorés tel qu'énoncé selon la revendication 1, dans lequel les au moins deux polymères fluorés ayant des points de fusion différents sont choisis parmi le groupe constitué du polytétrafluoroéthylène, du copolymère de tétrafluoroéthylène/perfluoro(éther d'alkyl vinyle), copolymère de tétrafluoroéthylène/hexafluoropropylène, copolymère d'éthylène/tétrafluoroéthylène, copolymère d'éthylène/chlorotrifluoroéthylène, polychlorotrifluoroéthylène, poly(fluorure de vinylidène), copolymère de fluorure de vinylidène/hexafluoropropylène, et copolymère de tétrafluoroéthylène/fluorure de vinylidène/hexafluoropropylène.

**3.** Procédé de moulage de polymères fluorés tel qu'énoncé selon la revendication 1, dans lequel les polymères fluorés sont le polytétrafluoroéthylène et le copolymère de tétrafluoroéthylène/perfluoro(éther d'alkyl vinyle).

**4.** Procédé de moulage de polymères fluorés tel qu'énoncé selon la revendication 1, dans lequel les polymères fluorés sont le polytétrafluoroéthylène et le copolymère de tétrafluoroéthylène/hexafluoropropylène.

**5.** Procédé de moulage de polymères fluorés tel qu'énoncé selon la revendication 2, dans lequel la chaleur de fusion cristalline ($\Delta$H) du polytétrafluoroéthylène est supérieure ou égale à 45 J/g.

**6.** Produit moulé de polymères fluorés obtenu par le procédé de moulage de polymères fluorés tel qu'énoncé selon la revendication 1.

**7.** Produit moulé de polymères fluorés tel qu'énoncé selon la revendication 6, dans lequel l'indice d'expansion linéaire entre 100°C et 150°C pour le produit moulé de polymères fluorés est inférieur ou égal à 15 x $10^{-5}$/°K.

**8.** Produit moulé de polymères fluorés tel qu'énoncé selon la revendication 6, dans lequel la densité relative du produit moulé de polymères fluorés est supérieure ou égale à 2,160.

1/1

**FIG. 1**

**FIG. 2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002167488 A
- JP 2003327770 A
- JP 374643 A
- JP 46014466 A
- JP 56026242 A